(19) Europäisches Patentamt
European Patent Office
Office européen des brevets

(11) **EP 4 575 605 A1**

(12) **EUROPÄISCHE PATENTANMELDUNG**

(43) Veröffentlichungstag:
**25.06.2025  Patentblatt 2025/26**

(21) Anmeldenummer: **24212390.9**

(22) Anmeldetag: **12.11.2024**

(51) Internationale Patentklassifikation (IPC):
*G02B 17/06* [(2006.01)]

(52) Gemeinsame Patentklassifikation (CPC):
**G02B 17/0642; G02B 17/0663**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **22.12.2023  DE 102023213267**

(71) Anmelder: **Carl Zeiss SMT GmbH**
**73447 Oberkochen (DE)**

(72) Erfinder:
• **Döring, Dirk**
  **07745 Jena (DE)**
• **Gölles, Michael**
  **07745 Jena (DE)**
• **Antrack, Torsten**
  **07745 Jena (DE)**

• **Epple, Alexander**
  **73447 Oberkochen (DE)**
• **Körner, Helmut**
  **73447 Oberkochen (DE)**
• **Perlitz, Sascha**
  **07745 Jena (DE)**
• **Matejka, Ulrich**
  **07745 Jena (DE)**
• **Reichmann, Lutz**
  **07745 Jena (DE)**
• **Rogalsky, Olaf**
  **73447 Oberkochen (DE)**
• **Schmidt, Sören**
  **07745 Jena (DE)**

(74) Vertreter: **Rau, Schneck & Hübner**
**Patentanwälte Rechtsanwälte PartGmbB**
**Königstraße 2**
**90402 Nürnberg (DE)**

(54) **VERGRÖSSERNDE ABBILDENDE OPTIK FÜR EIN METROLOGIESYSTEM ZUR UNTERSUCHUNG VON OBJEKTEN**

(57)   Eine vergrößernde abbildende Optik (20c) ist Teil eines Metrologiesystems zur Untersuchung von Objekten. Die vergrößernde abbildende Optik hat höchstens vier Spiegel (M1 bis M4), die ein Objektfeld (4) in einer Objektebene (17) in ein Bildfeld (21) in einer Bildebene (22) abbilden. Eine Eintrittspupille der vergrößernden abbildenden Optik hat nach einem Aspekt eine von einer Ellipse abweichende Berandungsform, deren Aspektverhältnis ungleich 1 ist. Reflexionsflächen von Kleinflächen-Spiegeln (M2, M3), die zur Führung von Abbildungslicht (3) längs eines Abbildungsstrahlengangs genutzt werden, weichen gemäß einem weiteren Aspekt von einer sphärischen Form um höchstens 10 μm ab. Es resultiert eine vergrößernde abbildende Optik, bei der bei gegebenen Fertigungsaufwand ein Abbildungsergebnis resultiert, welches die strengen Anforderungen eines Metrologiesystems erfüllt.

Fig. 4

## Beschreibung

Der Inhalt der deutschen Patentanmeldung DE 10 2023 213 267.2 wird durch Bezugnahme hierin aufgenommen.

Die Erfindung betrifft eine vergrößernde abbildende Optik für ein Metrologiesystem zur Untersuchung von Objekten. Ferner betrifft die Erfindung eine Beleuchtungsoptik für ein Metrologiesystem, angepasst an eine derartige abbildende Optik, ein optisches System mit einer derartigen abbildenden Optik und einer Beleuchtungsoptik sowie ein Metrologiesystem mit einem derartigen optischen System.

Ein Maskeninspektionssystem ist bekannt aus der US 8,842,284, aus der US 2013/0250428 A1, aus der WO 2016/012426 A1, aus der US 10,042,248 B2, der DE 102 20 815 A1 und aus der WO 2012/101269 A1. Die DE 10 2010 029 050 A1 und die DE 10 2011 084 255 A1 offenbaren jeweils eine vergrößernde abbildende Optik sowie ein Metrologiesystem mit einer derartigen abbildenden Optik. Die DE 10 2010 029 049 A1 offenbart ein Beleuchtungssystem für ein Metrologiesystem sowie ein Metrologiesystem mit einer derartigen Beleuchtungsoptik.

Es ist eine Aufgabe der vorliegenden Erfindung, eine vergrößernde abbildende Optik derart weiterzubilden, dass bei gegebenem Fertigungsaufwand gutes Abbildungsergebnis, welches die strengen Anforderungen eines Metrologiesystems erfüllt, resultiert.

Diese Aufgabe ist erfindungsgemäß gelöst durch eine vergrößernde abbildende Optik nach Anspruch 1.

Erfindungsgemäß wurde erkannt, dass eine nicht elliptische Eintrittspupille mit einem Aspektverhältnis ungleich 1 zusätzliche Anpassungsmöglichkeiten einer Führung des Abbildungsstrahlengangs innerhalb der vergrößerten abbildenden Optik insbesondere an einen Strahlengang von das Objektfeld beleuchtenden Beleuchtungslicht bietet, was eine Abbildungsqualität und/oder einen Lichtdurchsatz der abbildenden Optik verbessern kann. Die Berandungsform der Eintrittspupille kann angepasst sein an Abbildungsanforderungen, beispielsweise an unterschiedliche typische Objektstrukturgrößen in zwei aufeinander senkrecht stehenden Felddimensionen. Alternativ oder zusätzlich ist eine Anpassung an eine Beugungswirkung der Objektstrukturen und/oder auch an eine Beleuchtungspupille einer Beleuchtungsoptik des Metrologiesystems möglich, die ihrerseits eine Berandungsform mit einem Aspektverhältnis ungleich 1 hat.

Ein x:y-Aspektverhältnis der Eintrittspupille der vergrößernden abbildenden Optik kann im Bereich zwischen 1,1:1 und 5:1 liegen, wobei die x-Koordinate dabei senkrecht auf einer Meridionalebene der vergrößernden abbildenden Optik liegen kann. Das x:y-Aspektverhältnis kann beispielsweise 2:1 sein.

Eine kleinste sich hierbei ergebende objektseitige numerische Apertur der vergrößernden abbildenden Optik kann größer sein als 0,1, kann größer sein als 0,12 und kann beispielsweise 0,125 oder auch 0,135 betragen.

Eine Berandungsform der Eintrittspupille nach Anspruch 2 kann gut an bauliche Anforderungen und insbesondere an räumliche Anforderungen des Abbildungsstrahlengangs angepasst sein. Ein entsprechend hoher Lichtdurchsatz ist die Folge.

Entsprechendes gilt für eine Eintrittspupille mit einem Aussparungsabschnitt nach Anspruch 3. Der Aussparungsabschnitt kann einer Obskuration durch mindestens einen Spiegel der vergrößernden abbildenden Optik Rechnung tragen.

Bei einer Ausgestaltung nach Anspruch 4 kommen Vorteile einer Eintrittspupille mit einem Aspektverhältnis ungleich 1 besonders gut zu tragen. Der mindestens eine Spiegel, dessen Berandung derjenigen der Eintrittspupille entspricht, kann ein pupillennaher Spiegel sein. Es kann sich hierbei um den ersten und gegebenenfalls auch um den zweiten Spiegel der vergrößernden abbildenden Optik handeln.

Die Ausgestaltung nach Anspruch 5 schafft die Möglichkeit, ohne unerwünschte Abstriche an einer Abbildungsqualität die vergrößernde abbildende Optik mit Kleinflächen-Spiegeln auszuführen, die nur gering oder auch gar nicht von einer sphärischen Form abweichen. Dies erleichtert eine Herstellung der Kleinflächen-Spiegel der vergrößernden abbildenden Optik und bietet entsprechende Fertigungsvorteile.

Die Abweichung der Reflexionsflächen von einer sphärischen Form wird gemessen in Bezug auf eine sphärische Form, die an die jeweilige Spiegel-Reflexionsfläche bestangepasst ist. Eine derartige beste Anpassung kann durch Minimierung eines Fehlerquadrats beim Vergleich der jeweiligen Reflexionsfläche mit einer sphärischen Fläche ermittelt werden.

Die Abweichung der Reflexionsfläche des jeweiligen Kleinflächen-Spiegels von der sphärischen Form kann höchstens 5 $\mu$m sein, oder kann auch höchstens 1 $\mu$m sein. Bei einer derart geringen Abweichung ist eine Bearbeitung bei der Spiegelherstellung mit einer geringen Anzahl von Bearbeitungszyklen möglich. Der Kleinflächen-Spiegel kann als Nanoasphäre ausgeführt sein, bei dem eine Abweichung der Reflexionsfläche von einer sphärischen Form höchstens das Zehnfache der Nutzwellenlänge beträgt. Eine solche Nanoasphäre kann mit einer Messtechnik vermessen werden, die zur Vermessung einer sphärischen Reflexionsfläche ausgelegt ist.

Zwischen einem ersten und einem zweiten Spiegel im Abbildungsstrahlengang der vergrößernden abbildenden Optik kann ein Zwischenbild liegen. Es kann zur Verbesserung einer abbildungsfehlerkorrigierenden Wirkung genutzt werden. Zudem kann dies dazu genutzt werden, einen insbesondere kompakten Strahlangang im Bereich von den zwischenfokusnah beziehungsweise feldnah angeordneten Spiegeln zu schaffen.

Zur Charakterisierung einer derartigen Eigenschaft "feldnah" kann ein Parameter P herangezogen werden, der definiert ist in der WO 2009/024164 A1. Als feldnah gilt ein Spiegel dann, wenn der Parameter P kleiner ist als 0,5 und insbesondere kleiner ist als 0,4, kleiner als 0,3, kleiner als 0,25 oder auch kleiner als 0,2. Regelmäßig ist dieser Parameter P bei realen Spiegeln größer als 0,05.

Ein letzter Spiegel der vergrößernden abbildenden Optik im Abbildungsstrahlengang kann feldnah ausgeführt sein.

Ein erster und gegebenenfalls auch ein zweiter Spiegel im Abbildungsstrahlengang der vergrößernden abbildenden Optik kann pupillennah ausgeführt sein. Der Parameter P ist bei diesen pupillennahen Spiegeln größer als 0,5, kann größer sein als 0,6, kann größer sein als 0,7 und kann auch größer sein als 0,8. Regelmäßig ist bei einem realen pupillennahen Spiegel der Parameter P kleiner als 0,95.

Die vergrößernde abbildende Optik kann zur Nutzung mit EUV-Abbildungslicht insbesondere mit einer Wellenlänge ausgelegt sein, die im Bereich zwischen 5 nm und 30 nm liegt, beispielsweise 13,5 nm beträgt. Die vergrößernde abbildende Optik kann insbesondere für entsprechende EUV-Wellenlängen ausgeführte hochreflektierende Beschichtungen aufweisen.

Eine Baulänge der vergrößernden abbildenden Optik kann höchstens 1250 mm betragen, was zu einer kompakten Optik führt.

Die Spiegel der vergrößerten abbildenden Optik können so ausgeführt sein, dass keiner der Spiegel einen Durchmesser einer zur Führung des Abbildungslichts längs des Abbildungsstrahlengangs genutzten Reflexionsfläche aufweist, der größer ist als 400 mm. Auch dies führt zu einer kompakten Optik.

Bei einer Ausführung nach Anspruch 6 weichen die Reflexionsflächen aller Spiegel nur gering, nämlich um höchstens 25 μm, von einer sphärischen Form ab, also auch von Spiegeln mit einem Durchmesser, der mindestens 50 mm beträgt, die nachfolgend auch als Großflächen-Spiegel bezeichnet werden. Es resultieren entsprechende Fertigungsvorteile für alle Spiegel der vergrößernden abbildenden Optik. Die Abweichung der Reflexionsflächenspiegel von der sphärischen Form kann höchstens 20 μm betragen, höchstens 15 μm oder kann auch für alle Spiegel so groß sein, wie vorstehend im Zusammenhang mit dem mindestens einen Kleinflächenspiegel diskutiert.

Abstandsverhältnisse nach Anspruch 7 führen dazu, dass Imperfektionen und/oder Kontaminationen auf dem letzten Spiegel im Abbildungsstrahlengang der vergrößernden abbildenden Optik keine unerwünschten Auswirkungen auf eine Abbildungsqualität der Optik haben. Dies gilt insbesondere dann, wenn der letzte Spiegel als feldnaher Spiegel ausgeführt ist. Der Abstand des letzten Spiegels zur Bildebene kann größer sein als 65% eines Abstandes zwischen der Objektebene und der Bildebene. Regelmäßig ist dieser Abstand kleiner als der Abstand zwischen der Objektebene und der Bildebene.

Ein Abstand zwischen dem letzten und einem drittletzten Spiegel im Abbildungsstrahlengang der vergrößernden abbildenden Optik längs einer Koordinate senkrecht zur Bildebene kann, eine entsprechende Ausführung der vergrößernden abbildenden Optik vorausgesetzt, kleiner sein als 15%, kleiner als 12% oder auch kleiner sein als 10% des Abstandes zwischen der Objektebene und der Bildebene. Dieser Abstand zwischen dem letzten und dem drittletzten Spiegel ist regelmäßig größer als 1% des Abstandes zwischen der Objektebene und der Bildebene.

Ein Vergrößerungsverhältnis nach Anspruch 8 hat sich in der Praxis bewährt. Ein derartiges Vergrößerungsverhältnis kann an Pixelgrößen einer das Bildfeld erfassenden, ortsauflösenden Detektionseinrichtung des Metrologiesystems angepasst sein.

Die vergrößernde abbildende Optik kann ein Objektfeld mit einer Erstreckung in den beiden Objektfeld-Dimensionen im Bereich jeweils zwischen 0,1 mm und 1 mm haben und kann eine Fläche von beispielsweise 0,1 mm$^2$ bis 0,5 mm$^2$ haben. Eine typische Objektfelderstreckung ist 0,3 mm x 0,6 mm oder auch 0,5 mm x 0,5 mm.

Einfallswinkel nach den Ansprüchen 9 und 10 haben sich in der Praxis bewährt und führen zu günstigen Reflexionsbedingungen beziehungsweise zu guten Abbildungsverhältnissen. Ein Einfallswinkel auf den Spiegeln kann jeweils höchstens 13° betragen oder auch noch kleiner sein.

Ein RMS-Wellenfrontfehler nach Anspruch 11 führt zu einer guten Abbildungsqualität. Ein bildfeldseitiger Petzvalradius der vergrößernden abbildenden Optik kann größer sein als 500 mm.

Ein Mindestwert für eine Abweichung einer Spiegel-Reflexionsfläche von einer sphärischen Form nach Anspruch 12 hat sich in der Praxis bewährt. Bei einer Nutzwellenlänge von 13,5 nm entspricht dies einer Mindestabweichung, also einer Abweichungs-Untergrenze, von 25 nm. Je nach Ausführung der vergrößernden abbildenden Optik können mehrere, zum Beispiel zwei oder drei, Spiegel dieses Kriterium der Abweichungs-Untergrenze erfüllen oder auch genau einer der Spiegel. Bei einer weiteren Ausführung erfüllen alle Spiegel der vergrößernden abbildenden Optik diese Abweichungs-Untergrenze des Doppelten der Nutzwellenlänge.

Die Vorteile einer Beleuchtungsoptik nach Anspruch 13 entsprechen denen, die vorstehend in Zusammenhang mit den verschiedenen Aspekten der vergrößernden abbildenden Optik bereits erläutert wurden.

Eine Berandungsform der Beleuchtungspupille kann zumindest angenähert elliptisch sein, kann zumindest angenähert stadionförmig sein und kann auch zumindest angenähert halbkreisförmig sein.

Die Vorteile eines optischen Systems nach Anspruch 14 oder 15 und eines Metrologiesystems nach Anspruch 16 entsprechen denen, die vorstehend unter Bezugnahme auf die vergrößernde abbildende Optik und die Beleuchtungsoptik bereits erläutert wurden.

Bei der Lichtquelle des Metrologiesystems kann es sich um eine EUV-Lichtquelle handeln.

Die Detektionseinrichtung kann mindestens eine TDI-Kamera aufweisen.

Das Metrologiesystem kann als Maskeninspektionssystem oder auch als Waferinspektionssystem ausgeführt sein.

Das Inspektionssystem kann einen Objekthalter zur Halterung des zu inspizierenden Objektes aufweisen, der mit einem Objektverlagerungsantrieb mechanisch gekoppelt ist, so dass eine scannende Verlagerung des Objekts bei der Beleuchtung möglich ist.

Beim Inspektionssystem kann es sich um ein System für die aktinische Masken- bzw. Waferinspektion handeln.

Ein Ausführungsbeispiel der Erfindung wird nachfolgend anhand der Zeichnung näher erläutert. In dieser zeigen:

Fig. 1    schematisch in einem Meridionalschnitt ein Maskeninspektionssystem für Lithographiemasken zum Einsatz mit EUV-Beleuchtungslicht, mit einem Beleuchtungssystem, aufweisend eine Energie-Detektions-Baugruppe mit einem strahlhomogenisierenden Element, mit einer abbildenden Optik und mit mindestens einer EUV-Energiesensor-Einrichtung;

Fig. 2    in einem Meridionalschnitt eine schematische Ansicht einer weiteren Ausführung einer abbildenden Optik, die anstelle der abbildenden Optik nach Fig. 1 beim Maskeninspektionssystem zum Einsatz kommen kann;

Fig. 3    Eine schematische Ansicht der abbildenden Optik aus Blickrichtung III in Fig. 2;

Fig. 4    in einem Meridionalschnitt eine weitere Ausführung einer abbildenden Optik, die anstelle der abbildenden Optik nach Fig. 1 beim Maskeninspektionssystem zum Einsatz kommen kann;

Fig. 5    in Pupillenkoordinaten eine Eintrittspupille der abbildenden Optik nach Fig. 4;

Fig. 6    in einem Meridionalschnitt eine Ausführung einer abbildenden Optik, die anstelle der abbildenden Optik nach Fig. 1 beim Maskeninspektionssystem zum Einsatz kommen kann; und

Fig. 7    in Pupillenkoordinaten eine Eintrittspupille der abbildenden Optik nach Fig. 6.

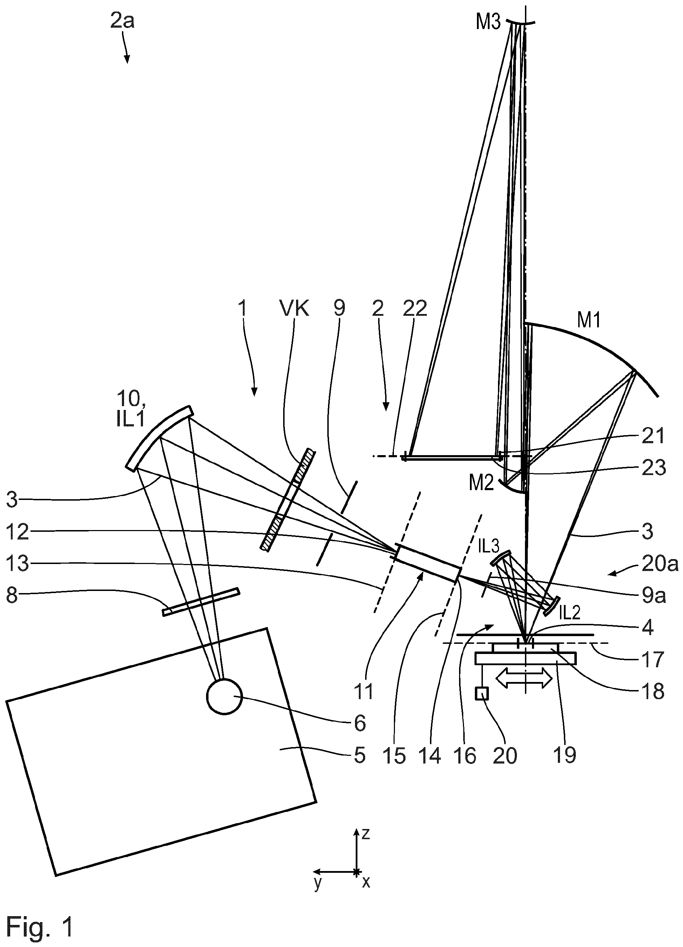

Eine Beleuchtungsoptik 1 ist Bestandteil eines optischen Systems 2 eines Maskeninspektionssystems 2a zum Einsatz mit EUV-Beleuchtungslicht 3. Ein Strahlengang des Beleuchtungslichts 3 ist in der Fig. 1 für die Beleuchtungsoptik 1 über Randstrahlen und einen Hauptstrahl veranschaulicht. Beleuchtet wird mit dem Beleuchtungslicht 3 ein Beleuchtungsfeld 4 des Maskeninspektionssystems.

Das Beleuchtungslicht 3 wird von einer EUV-Lichtquelle 5 in einen Quellbereich 6 erzeugt. Die Lichtquelle 5 kann EUV-Nutzstrahlung in einem Wellenlängenbereich zwischen 2 nm und 30 nm, beispielsweise im Bereich zwischen 2,3 nm und 4,4 nm oder im Bereich zwischen 5 nm und 30 nm, beispielsweise bei 13,5 nm, erzeugen.

Die Lichtquelle 5 ist als Plasma-Lichtquelle ausgeführt. Es kann sich hierbei beispielsweise um eine Laser-Plasma-Quelle (LPP; laser produced plasma) oder auch um eine Entladungsquelle (DPP; discharge produced plasma) handeln. Derartige Plasma-Quellen sind als Lichtquellen für EUV-Projektionsbelichtungsanlagen im Prinzip bekannt. Alternativ kann die Lichtquelle 5 auch als High-Harmonic EUV-Quelle ausgeführt sein. Eine Pulsfrequenz der Lichtquelle 5 kann im kHz-Bereich liegen.

Zur Erleichterung von Lagebeziehungen wird nachfolgend ein kartesisches xyz-Koordinatensystem verwendet. Die x-Achse steht senkrecht auf der Zeichenebene der Figur 1 und verläuft in diese hinein. Die y-Achse verläuft in der Figur 1 horizontal nach links und die z-Achse verläuft in der Figur 1 vertikal nach oben.

Nach Emission durch die Lichtquelle 5 passiert das Beleuchtungslicht 3 zunächst einen Nutzlicht-Filter 8, der in einer Betriebsposition im Strahlengang des Beleuchtungslichts 3 zwischen dem Quellvolumen 6 und einem ersten Ellipsoid-Spiegel IL1 der Beleuchtungsoptik 1 angeordnet ist. Der Nutzlicht-Filter 8 kann ein Filter einer Mehrzahl von Filtern sein, die beim Metrologiesystem 2a beispielsweise in einem Filtermagazin vorgehalten werden. Ein weiterer Nutzlicht-Filter kann in einer Warteposition außerhalb des Beleuchtungslicht-Strahlengangs der Beleuchtungsoptik 1 angeordnet sein. Die Nutzlicht-Filter 8 können die gleiche Transmissionscharakteristik aufweisen, wobei dann ein Wechsel zwischen den Nutzlicht-Filtern vorgenommen werden kann, wenn eine Degradation einer Filterwirkung des Betriebs-Nutzlicht-Filters 8 festgestellt ist. Alternativ können die Nutzlicht-Filter auch unterschiedliche Filtercharakteristiken aufweisen und beispielsweise verschiedene Nutzlicht-Wellenlängenbereiche in den nachfolgenden Beleuchtungslicht-Strahlengang durchlassen bzw. zur Herausfilterung unterschiedlicher Falschlicht-Anteile optimiert sein.

Die Nutzlicht-Filter können derart ausgebildet sein, dass sie insbesondere im Beleuchtungslicht-Strahlengang mitgeführtes Pumplicht, das bei der Nutzlichterzeugung im Quellvolumen 6 genutzt wurde, herausfiltern.

Nach dem Filter 8 und dem Spiegel IL1 durchtritt das Beleuchtungslicht 3 zunächst eine ein Bündel des Beleuchtungslichts 3 randseitig begrenzende Aperturblende 9. Im Anschluss hieran wird das Beleuchtungslicht-Bündel 3 hin zu einem strahlhomogenisierenden Element 11 der Beleuchtungsoptik 1 überführt. Der Spiegel IL1 dient dabei als Einkoppeloptik 10 zur Einkopplung des Beleuchtungslichts 3 in das strahlhomogenisierende Element 11.

Zwischen dem Quellvolumen 6 und dem strahlhomogenisierenden Element 11, im Regelfall nach dem ersten Spiegel IL1 der Beleuchtungsoptik 1, passiert das Beleuchtungslicht 3 eine Öffnung in einer Wand einer Vakuumkammer VK, die in der Fig. 1 im Beleuchtungslicht-Strahlengang zwischen dem Spiegel IL1 und der Beleuchtungslicht-Aperturblende 9 angedeutet ist.

Die Aperturblende 9 begrenzt eine numerische Apertur des vom Quellbereichs 6 emittierten Beleuchtungslicht-Bündels 3 auf einen Wert der numerischen Apertur im Bereich zwischen 0,02 und 0,2, beispielsweise im Bereich zwischen 0,07 und 0,15 oder auch im Bereich zwischen 0,05 und 0,08. Alternativ oder zusätzlich zur Aperturblende 9 kann eine aperturbegrenzende Blende zwischen dem strahlhomogenisierenden Element 11 und einer nachfolgenden optischen Komponente der Beleuchtungsoptik 1 angeordnet sein, wie in der Fig. 1 bei 9a angedeutet. Auch eine Anordnung einer derartigen weiteren Aperturblende im Strahlengang des Beleuchtungslichts 3 nach dem strahlhomogenisierenden Element 11 zwischen zwei nachgeordneten optischen Komponenten der Beleuchtungsoptik 1 ist möglich.

Der Ellipsoid-Spiegel IL1 dient zur Abbildung des Quellbereichs 6 der EUV-Lichtquelle 5 in eine Eintrittsöffnung 12 in einer Eintrittsebene 13 des strahlhomogenisierenden Elements 11. Ein erster Brennpunkt des Ellipsoid-Spiegels IL1 liegt also im Quellbereich 6 und ein zweiter Brennpunkt des Ellipsoid-Spiegels IL1 in der Eintrittsöffnung 12. Mit dem Ellipsoid-Spiegel IL1 wird das Beleuchtungslicht-Bündel 3 in die Eintrittsöffnung 12 in der Eintrittsebene 13 des strahlhomogenisierenden Elements 11 fokussiert. Eine eintrittsseitige numerische Apertur des Beleuchtungslicht-Bündels 3 beim Eintritt in die Eintrittsöffnung 12 kann im Bereich von 0,02 bis 0,2, beispielsweise im Bereich von 0,05 liegen.

Ein Einfallswinkel eines zentralen Hauptstrahls des Beleuchtungslicht-Bündels 3 auf dem Einkoppel-Spiegel IL1 kann im Bereich zwischen 10° und 20° liegen. Der Ellipsoid-Spiegel IL1 kann ein Spiegel für normalen Einfall (Normal Incidence, NI) sein, kann aber auch als Spiegel mit streifendem Einfall (Grazing Incidence, GI) ausgeführt sein.

Die Eintrittsöffnung 12 und eine Austrittsöffnung 14 des strahlhomogenisierenden Elements 11 sind jeweils quadratisch oder rechteckig mit typischen Dimensionen im Bereich zwischen 0,5 mm und 5 mm und beispielsweise zwischen 0,5 mm und 2 mm oder auch zwischen 0,5 mm und 1 mm. Ein Aspektverhältnis der Eintrittsöffnung 12 und einer gleichgroßen Austrittsöffnung 14 des strahlhomogenisierenden Elements 11 für das Beleuchtungslicht 3 in einer Austrittsebene 15 liegt zwischen 0,5 und 2. Eine typische Größe der Eintrittsöffnung 12 und der Austrittsöffnung 14 des strahlhomogenisierenden Elements 11 beträgt z.B. 0,5 mm x 1,0 mm, 0,75 mm x 0,75 mm, 1,0 mm x 2,0 mm oder 1,5 mm x 2,0 mm.

Das strahlhomogenisierende Element 11 kann als Hohlwellenleiter ausgeführt sein.

Das strahlhomogenisierende Element 11 hat eine typische Länge senkrecht zu den Ebenen 13 und 15, also längs einer Haupt-Strahlrichtung des Beleuchtungslichts 3, im Bereich zwischen 50 mm und 500 mm, z. B. im Bereich zwischen 50 mm und 150 mm, insbesondere im Bereich zwischen 50 mm und 100 mm.

Ein Winkel zwischen einer Normalen auf die Eintrittsebene 13 des strahlhomogenisierenden Elements 11 und dem in die Eintrittsöffnung 12 einfallenden Hauptstrahl des Beleuchtungslicht-Bündels 3 kann bei 0° liegen oder kann alternativ auch von 0° verschieden sein und beispielsweise im Beriech zwischen 0° und 1,5°, beispielsweise zwischen 0,25° und 0,75° und insbesondere im Bereich von 0,5° liegen.

Ein Verhältnis aus dem Abstandes zwischen der Eintrittsebene 13 und der Austrittsebene 15, und einer Größe bzw. dem typischen Durchmesser der Eintrittsöffnung bzw. der Austrittsöffnung 12, 14, liegt im Bereich zwischen 50 und 1000 und kann beispielsweise im Bereich zwischen 50 und 200 liegen.

Eine dem strahlhomogenisierenden Element 11 nachgeordnete abbildende Auskoppel-Spiegeloptik 16 mit zwei Spiegeln IL2, IL3 bildet die in einer Austrittsebene 15 liegende Austrittsöffnung 14 des strahlhomogenisierenden Elements 11 in das Beleuchtungsfeld 4 in einer Objektebene 17 ab. Eine bildseitige numerische Apertur dieser Abbildung kann im Bereich von 0.05 bis 0.2 liegen.

Bei der dargestellten Ausführung hat die Auskoppel-Spiegeloptik 16 genau zwei Spiegel, nämlich die Spiegel IL2 und IL3. Die vorstehend erläuterte, gegebenenfalls zum Einsatz kommende Aperturblende nach dem strahlhomogenisierenden Element 11 kann zwischen dem strahlhomogenisierenden Element 11 und dem Spiegel IL2 oder auch zwischen den Spiegeln IL2 und IL3 angeordnet sein.

Die Auskoppel-Spiegeloptik 16 ist nach Art eines Wolter-Teleskops, nämlich nach Art einer Wolter-Optik Typ I, ausgeführt. Derartige Wolter-Optiken sind beschrieben in J. D. Mangus, J. H. Underwood "Optical Design of a Glancing Incidence X-ray Telescope", Applied Optics, Vol. 8, 1969, Seite 95, und den dort angegebenen Referenzen. Anstelle eines Paraboloids kann bei derartigen Wolter-Optiken auch ein Hyperboloid eingesetzt werden. Auch eine solche Kombination eines Ellipsoid-Spiegels mit einem Hyperboloid-Spiegel stellt eine Wolter-Optik vom Typ I dar.

Ein Ausführungsbeispiel für die Auskoppel-Spiegeloptik 16 ist beschrieben in der US 10,042,248 B2.

Ein Abbildungsfaktor $\beta_1$ der Einkoppel-Spiegeloptik 10 kann im Bereich zwischen 0,1 und 50 liegen, kann also um einen Faktor 10 verkleinernd bis hin zu einem Faktor 50 vergrößernd wirken. Ein Abbildungsfaktor $\beta_2$ der Auskoppel-Spiegeloptik 16 kann im Bereich zwischen 0,02 und 10 liegen, kann also seinerseits wiederum um einen Faktor 50 verkleinern bis hin zu einem Faktor vergrößern. Ein Produkt $\beta_1$, $\beta_2$ der beiden Abbildungsfaktoren kann bei der Beleuchtungsoptik 1 im Bereich zwischen 0,25 und 10 liegen.

In der Objektebene 17 ist ein zu inspizierendes Retikel 18 als zu inspizierendes Objekt bzw. zu inspizierende Maske angeordnet, das von einem Retikelhalter 19 gehalten ist. Der Retikelhalter 19 steht mit einem Retikelverlagerungsantrieb 20 in mechanischer Wirkverbindung, über den das Retikel 18 längs einer Objektverlagerungsrichtung y während einer Maskeninspektion verlagert wird. Hierüber ist eine scannende Verlagerung des Retikels 18 in der Objektebene 17 möglich.

Das Beleuchtungsfeld 4 hat eine typische Dimension in der Objektebene 17, die kleiner ist als 1.5 mm. Die Erstreckung des Beleuchtungsfeldes 4 beträgt bei der dargestellten Ausführung 1 mm in der x-Richtung und 0,5 mm in der y-Richtung.

Das x/y-Aspektverhältnis des Beleuchtungsfelds 4 stimmt mit dem x/y-Aspektverhältnis der Austrittsöffnung 14 überein.

Das Beleuchtungsfeld 4 bzw. ein Teil des Beleuchtungsfelds 4, der dann ein Objektfeld darstellt, wird mit einer Projektionsoptik 20a in ein Bildfeld 21 in einer Bildebene 22 abgebildet. Eine Größe des Bildfeldes 21 kann im Bereich von 150 mm x 300 mm liegen. Die kürzere Bildfeld-Erstreckung verläuft längs der Scanrichtung y.

Die Projektionsoptik 20a hat ein Vergrößerungsverhältnis der Abbildung des Objekt- beziehungsweise Beleuchtungsfeldes 4 in das Bildfeld 21 von 500. Je nach Ausführung der Projektionsoptik 20a kann dieses Vergrößerungsverhältnis im Bereich zwischen 250 und 500 liegen.

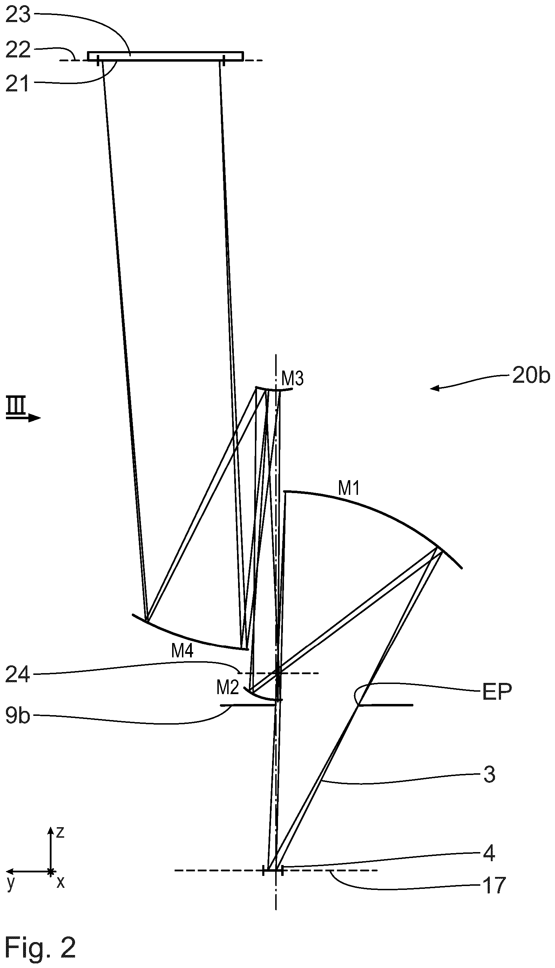

Die Projektionsoptik 20a hat im Abbildungs-Strahlengang der Projektionsoptik 20a durchnummerierte Spiegel M1, M2, M3 weist also insgesamt drei Spiegel auf. Je nach Ausführung der Projektionsoptik 20a kann die Anzahl der Spiegel auch größer sein als drei. Weitere Ausführungen, die anstelle der Projektionsoptik 20a zum Einsatz kommen können, werden nachfolgend anhand der Fig. 2 ff. noch erläutert.

In einer Eintritts-Pupillenebene EP der Projektionsoptik 20a, die im Abbildungs-Strahlengang des Beleuchtungs- bzw. Abbildungslichts zwischen dem reflektierenden Retikel 18 und dem ersten Spiegel M1 liegt, ist eine Aperturblende 9b angeordnet. Diese Aperturblende 9b kann auch zur Vorgabe einer gegebenenfalls vorliegenden inneren Obskuration der Projektionsoptik 20a dienen.

Die Spiegel M1 und M2 der Projektionsoptik 20a sind als NI-Spiegel mit einem Einfallswinkel des Beleuchtungs- und Abbildungslichts 3 von weniger als 45° ausgeführt. Ein maximaler Einfallswinkel von Einzelstrahlen des Beleuchtungslichts 3 auf den Spiegeln M1 und M2 liegt im Bereich von 14°.

Das Beleuchtungs- beziehungsweise Abbildungslicht 3 trifft auf das Bildfeld 21 mit einem Einfallswinkel auf, der kleiner ist als 5°.

Der Spiegel M1 hat eine Berandung einer Reflexionsfläche, die zur Führung des Abbildungs- beziehungsweise Beleuchtungslichts 3 längs des Abbildungsstrahlengangs genutzt wird, die der Berandung einer Eintrittspupille EP, die von der Aperturblende 9b vorgegeben wird, entspricht.

Mindestens einer der Spiegel M1 und M2 kann als asphärischer Spiegel ausgeführt sein. Die Projektionsoptik 20a kann einen asphärischen Spiegel oder kann zwei asphärische Spiegel aufweisen.

Die Beleuchtungsoptik 1 des Metrologiesystems 2a hat ihrerseits eine Beleuchtungspupille, vorgegeben über die Aperturblende 9b, die an die Eintrittspupille EP angepasst ist. Diese Beleuchtungspupille der Beleuchtungsoptik 1 kann eine von einer Ellipse abweichende Berandungsform aufweisen, deren Aspektverhältnis ungleich 1 ist. Die Beleuchtungspupille kann eine angenähert elliptische, eine angenähert stadionförmige oder auch eine angenähert halbkreisförmige Berandungsform mit einem entsprechenden, von 1 abweichenden Aspektverhältnis aufweisen. Das Aspektverhältnis der Beleuchtungspupille kann demjenigen der Eintrittspupille EP der abbildenden Optik 20a entsprechen.

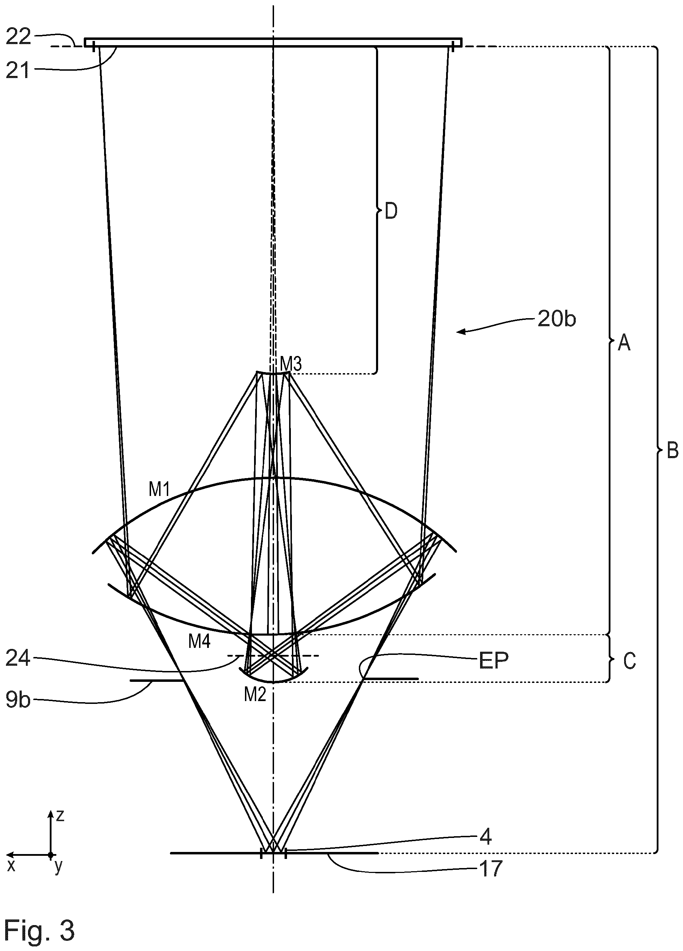

Anhand der Fig. 2 und 3 wird nachfolgend eine weitere Ausführung einer Projektionsoptik 20b beschrieben, die anstelle der Projektionsoptik 20a beim Maskeninspektionssystem 2a zum Einsatz kommen kann. Komponenten und Funktionen, die denjenigen entsprechen, die vorstehend unter Bezugnahme auf die Fig. 1 bereits beschrieben wurden, tragen insbesondere die gleichen Bezugsziffern und werden nicht nochmals im Einzelnen diskutiert.

Die Projektionsoptik 20b hat im Abbildungsstrahlengang zwischen dem Objekt- beziehungsweise Beleuchtungsfeld 4 und dem Bildfeld 21 insgesamt 4 Spiegel M1, M2, M3 und M4, die wiederum in der Reihenfolge ihrer Beaufschlagung mit dem Beleuchtungs- beziehungsweise Abbildungslicht 3 durchnummeriert sind. Der Abbildungsstrahlengang der Projektionsoptik 20b ist in der Fig. 2 durch Randstrahlen veranschaulicht, die von zwei zueinander beabstandeten Objekt-Feldpunkten ausgehen. In der Ansicht nach Fig. 3 sind dies drei voneinander beabstandete Feldpunkte.

Mindestens einer der Spiegel M1 bis M4 kann als asphärischer Spiegel ausgeführt sein. Die Projektionsoptik 20b kann einen asphärischen Spiegel, kann zwei asphärische Spiegel oder auch drei asphärische Spiegel aufweisen. Auch alle vier Spiegel der Projektionsoptik 20b können asphärisch ausgeführt sein.

Zwischen dem Objektfeld 4 und dem Spiegel M1 liegt eine Eintrittspupillenebene, in der die Aperturblende 9b angeordnet ist.

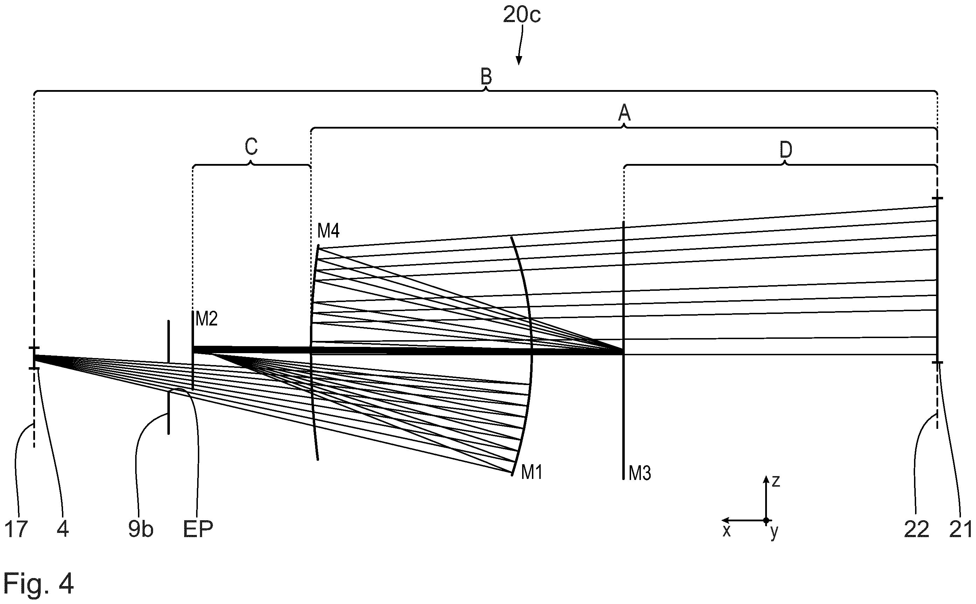

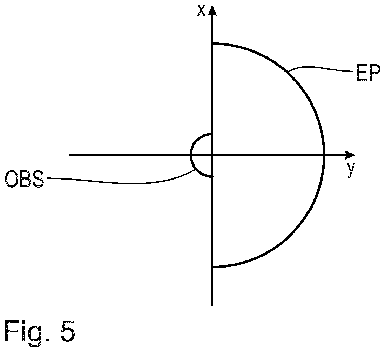

Eine Berandungsform einer Eintrittspupille EP der Projektionsoptik 20b, die von einer inneren Berandung der Aperturblende 9b vorgegeben wird, ist halbkreisförmig und entspricht der Form der Eintrittspupille, die nachfolgend noch im Zusammenhang mit der weiteren Ausführung der Projektionsoptiken aus den Fig. 4 und 5 erläutert wird.

Eine Durchmessererstreckung dieser Halbkreisform der Eintrittspupille EP verläuft parallel zur x-Koordinate. Im Bereich eines entsprechenden, längs der x-Koordinate verlaufenden Durchmesser-Berandungsschnittes der Eintrittspupille EP wird die Eintrittspupille EP begrenzt von einer durch den Spiegel M2 hervorgehobenen Obskuration.

Ein x:y-Aspektverhältnis der Eintrittspupille EP beträgt bei der Projektionsoptik 20b 2:1. Je nach Ausführung der Projektionsoptik 20b kann dieses Aspektverhältnis im Bereich zwischen 5:1 und 1,1:1 liegen. Eine objektseitige numerische Apertur der Projektionsoptik 20b liegt in der yz-Ebene nach Fig. 2 bei etwa 0,125 (NAy=0,125) und in der hierzu senkrechten xz-Ebene bei etwa 0,25 (NAx=0,25). Je nach Ausführung der Projektionsoptik 20b kann die NAx zwischen 0,1 und 0,5 liegen und die NAy zwischen 0,05 und 0,25.

Zwischen den Spiegeln M1 und M2 liegt im Abbildungsstrahlengang der Projektionsoptik 20b ein Zwischenbild 24.

Auf den Spiegeln M1 und M2 haben Einzelstrahlen, die zu verschiedenen Feldpunkten, aber gleichen Beleuchtungswinkeln gehören, einen vergleichsweise geringen Abstand zueinander, der höchstens ein Viertel eines gesamten genutzten Reflexionsflächendurchmessers des jeweiligen Spiegels beträgt. Ein Parameter P, der eine Feld- beziehungsweise Pupillennähe des jeweiligen Spiegels charakterisiert und definiert ist in der WO 2009/024164 A1, liegt bei den Spiegeln M1 und M2 jeweils bei einem Wert von P>0,5. Die Spiegel M1 und M2 sind daher pupillennah. Insbesondere ist der Spiegel M1 ein pupillennaher Spiegel.

Auf den Spiegeln M3 und M4 haben Einzelstrahlen, die zu gleichen Feldpunkten, aber unterschiedlichen Beleuchtungswinkeln gehören, wiederum einen Abstand zueinander, der höchstens ein Viertel eines gesamten genutzten Reflexionsflächendurchmessers des jeweiligen Spiegels beträgt der Parameter P (vgl. wiederum die Definition aus der WO 2009/024164 A1) ist bei den Spiegeln M3 und M4 jeweils kleiner als 0,5. Die Spiegel M3 und M4 sind daher im Abbildungsstrahlengang der Projektionsoptik 20b feldnah angeordnete Spiegel. Insbesondere ist der Spiegel M4 ein feldnaher Spiegel.

Eine Berandung einer Reflexionsfläche des Spiegels M1, die zur Führung des Abbildungslichts 3 längs des Abbildungsstrahlengangs genutzt wird, entspricht der Berandung der Eintrittspupille EP. Dies gilt näherungsweise auch für den Spiegel M2. Eine Berandungsform ist beim Spiegel M2 im Vergleich zur Berandung des Spiegels M1 und auch zur Berandung der Eintrittspupille EP um die xz-Ebene gespiegelt.

Eine Berandung einer Reflexionsfläche des Spiegels M4, die zur Führung des Abbildungslichts 3 längs des Abbildungsstrahlengangs genutzt wird, entspricht einer Berandung des Bildfeldes 21, die regelmäßig rechteckig oder quadratisch ausgeführt ist. In ähnlicher Form gilt dies auch für den Spiegel M3.

Der Spiegel M4, also der im Abbildungsstrahlengang letzte Spiegel, hat einen Abstand A zur Bildebene 22, der größer als 60% eines Abstandes B zwischen der Objektebene 17 und der Bildebene 22 ist.

Ein Abstand C zwischen den Spiegeln M4 und M2, also ein Abstand zwischen dem letzten und dem drittletzten Spiegel längs einer Koordinate senkrecht zur Bildebene 22, ist kleiner als 15% des Abstandes B zwischen der Objektebene 17 und der Bildebene 22.

Ein Abstand D zwischen dem vorletzten Spiegel M3 im Abbildungsstrahlengang der Projektionsoptik 20b und der Bildebene 22 ist größer als 20%, größer als 25%, größer als 30% und auch größer als 35% des Abstandes B zwischen den Feldebenen 17, 22.

Die Projektionsoptik 20b hat wiederum ein Vergrößerungsverhältnis bei der Abbildung des Objektfeldes 4 in das Bildfeld 21 im Bereich zwischen 250 und 500.

Einzelstrahlen haben innerhalb des Abbildungsstrahlengangs bei der Projektionsoptik 20b einen Einfallswinkel auf den Spiegel M1 bis M4, die jeweils maximal 13° betragen. Ein Einfallswinkel der Einzelstrahlen des Abbildungslichts 3 auf das Bildfeld 21 beträgt bei der Projektionsoptik 20b maximal 5°.

Anhand der Fig. 4 und 5 wird nachfolgend eine weitere Ausführung einer Projektionsoptik 20c erläutert, die anstelle der vorstehend beschriebenen Projektionsoptiken beim Maskeninspektionssystem 2a zum Einsatz kommen kann. Komponenten und Funktionen, die denjenigen entsprechen, die vorstehend unter Bezugnahme auf die Fig. 1 bis 3 bereits beschrieben wurden, tragen insbesondere die gleichen Bezugsziffern und werden nicht nochmals im Einzelnen diskutiert.

Ein Abbildungsstrahlengang der Projektionsoptik 20c entspricht grundsätzlich demjenigen der Projektionsoptik 20b.

Ein Abstand A zwischen dem Spiegel M4 und der Bildebene 22 beträgt etwa 69% des Abstandes B zwischen der Objektebene 17 und der Bildebene 22. Ein Abstand C zwischen den Spiegeln M4 und M2 beträgt etwa 13% des Abstandes B.

Bei der Projektionsoptik 20c beträgt der Abstand D zwischen dem im Abbildungsstrahlengang vorletzten Spiegel M3 und der Bildebene 22 etwa 35% des Abstandes B zwischen den Feldebenen 17, 22.

Die objektfeldseitige numerische Apertur NAx beträgt bei der Projektionsoptik 20c 0,27. Die objektfeldseitige numerische Apertur NAy beträgt 0,135. Die objektseitige Feldgröße beträgt 0.74mm x 0.28mm mit einem Offset des Feldes von 0.06mm in y.

Die Projektionsoptik 20c hat ein Vergrößerungsverhältnis von 435.

Der Abstand A ist bei der Projektionsoptik 20c so groß, dass eine Imperfektion auf der Reflexionsfläche des Spiegels M4 mit einer typischen Größe von 0,16 mm nicht zur Abschattung einer Pixeldimension im Bildfeld 21 führt.

Kein Einzelstrahl innerhalb des Abbildungsstrahlengangs der Projektionsoptik 20c hat einen Einfallswinkel auf einen der Spiegel M1 bis M4, der größer ist als 13°.

Das Abbildungslicht 3 trifft auf das Bildfeld 21 bei der Projektionsoptik 20c mit einem Einfallswinkel auf, der kleiner ist als 5°.

Ein Wellenfrontfehler RMS über das Bildfeld 21 beträgt bei der Projektionsoptik 20c höchstens 20 mλ, nämlich im Falle des Ausführungsbeispiels der Projektionsoptik 20c 10 mλ. Ein bildfeldseitiger Petzvalradius ist bei der Projektionsoptik 20c größer als 500 mm. Eine bildfeldseitige Verzeichnung beträgt 1 nm.

Die Spiegel M1 und M2 haben jeweils eine Berandung einer Reflexionsfläche, die zur Führung des Abbildungs-beziehungsweise Beleuchtungslichts 3 längs des Abbildungsstrahlengangs genutzt wird, die der Berandung der Eintrittspupille EP entspricht. Eine Berandungsform ist beim Spiegel M2 dabei im Vergleich zur in der Fig. 5 dargestellten Berandungsform der Eintrittspupille EP um die xz-Ebene gespiegelt.

Nachfolgend werden optische Designdaten der Projektionsoptik 20c in Tabellen 1a/b zusammengefasst.

Die erste Spalte der Tabelle 1a gibt die jeweilige optische Fläche, beginnend mit dem Objektfeld 4, an.

Die zweite Spalte der Tabelle 1a gibt einen Krümmungsradius der jeweiligen optischen Fläche an.

Die folgende Spalte der Tabelle 1a gibt einen Krümmungsradius der an die optische Fläche angepassten Sphäre an.

Die vierte Spalte der Tabelle 1a gibt einen z-Abstand zur jeweils vorhergehenden Fläche an.

Die fünfte Spalte der Tabelle 1a gibt eine optische Wirkung der Fläche an, falls eine solche optische Wirkung vorhanden ist. Diese optische Wirkung ist bei den Spiegeln M1 bis M4 "REFL", also reflektiv.

Die erste Spalte der Tabelle 1b zeigt einen maximalen Wert einer Einfallshöhe (Abstand senkrecht zur optischen Achse) der jeweiligen Flächenbeschreibung der optischen Fläche in mm an.

Die zweite Spalte der Tabelle 1b gibt eine maximale Abweichung der jeweiligen asphärischen optischen Fläche von der bestangepassten Sphäre, wiederum in mm, an.

Zusätzlich sind für die Spiegelflächen der Spiegel M1, M2 und M4 in der nachfolgenden Tabelle 2 noch Koeffizienten K, $C_1$, $C_2$ und $C_3$ gemäß der folgenden Asphären-Flächenformel angegeben:

$$p(h) = [((1/r)h^2)/(1 + \mathrm{SQRT}(1 - (1 + K)(1/r)^2 h^2))] + C_1 \cdot h^4 + C_2 \cdot h^6 + C_3 h^8 \ldots.$$

Dabei ist p die Pfeilhöhe, h die Einfallshöhe, r der Krümmungsradius,

K ist die konische Konstante und $C_1$, $C_2$ und $C_3$ sind die ersten drei geraden Koeffizienten des Asphären-Korrekturpolynoms.

Die Abweichung von der bestangepassten Sphäre ergibt sich aus der Differenz der Pfeilhöhen gemäß der Flächenformel der Asphäre und der bestangepassten Sphäre.

Tabelle 1a zu Fig. 4/5

| Optische Fläche | Radius [mm] | Radius bestangepasste Sphäre [mm] | Dicke [mm] | Wirkung |
|---|---|---|---|---|
| Objektfeld | Unendlich | | 0.000 | |
| 1: | Unendlich | | 297.654 | |
| Aperturblende | Unendlich | | 0.000 | |
| 3: | Unendlich | | 391.216 | |
| M1 | 540,167 | 541.1 | -470.928 | reflektierend |
| M2 | 51,130 | 51.226 | 598.100 | reflektierend |
| M3 | -44,815 | -44.815 | -434.431 | reflektierend |
| M4 | 1174,354 | 1174,824 | 867.233 | reflektierend |

(fortgesetzt)

| Optische Fläche | Radius [mm] | Radius bestangepasste Sphäre [mm] | Dicke [mm] | Wirkung |
|---|---|---|---|---|
| Bildfeld | Unendlich | | 0.000000 | |

Tabelle 1b zu Fig. 4/5

| Optische Fläche | Max. Einfallshöhe [mm] | Max. Abweichung Asphäre von Sphäre [mm] |
|---|---|---|
| Objektfeld | | |
| 1: | | |
| Aperturblende | 83.5 | |
| 3: | | |
| M1 | 185 | 0.0150 |
| M2 | 11.5 | 0.0007 |
| M3 | 7.7 | 0 |
| M4 | 160 | 0.009 |
| Bildfeld | | |

Tabelle 2 zu Fig. 4/5

| Spiegel | K | $C_1$ | $C_2$ | $C_3$ |
|---|---|---|---|---|
| M1 | -0.0572 | 0.000000E+00 | 0.135E-17 | 0.779E-23 |
| M2 | -0.1520 | 0.000000E+00 | 0.360E-10 | 0.202E-13 |
| M4 | -0.6361 | 0.000E+00 | -0.576E-18 | 0.795E-22 |

Die Spiegel M1, M2 und M4 sind bei der Projektionsoptik 20c also als Asphären ausgeführt. Der Spiegel M3 ist ein sphärischer Spiegel.

In der Fig. 5 ist bei OBS noch eine Obskurationswirkung des Spiegels M2 in Bezug auf die Eintrittspupille EP verdeutlicht. Der Spiegel M2 ist so ausgeführt, dass das die Obskuration OBS nicht mit der halbkreisförmigen Eintrittspupille EP überlappt.

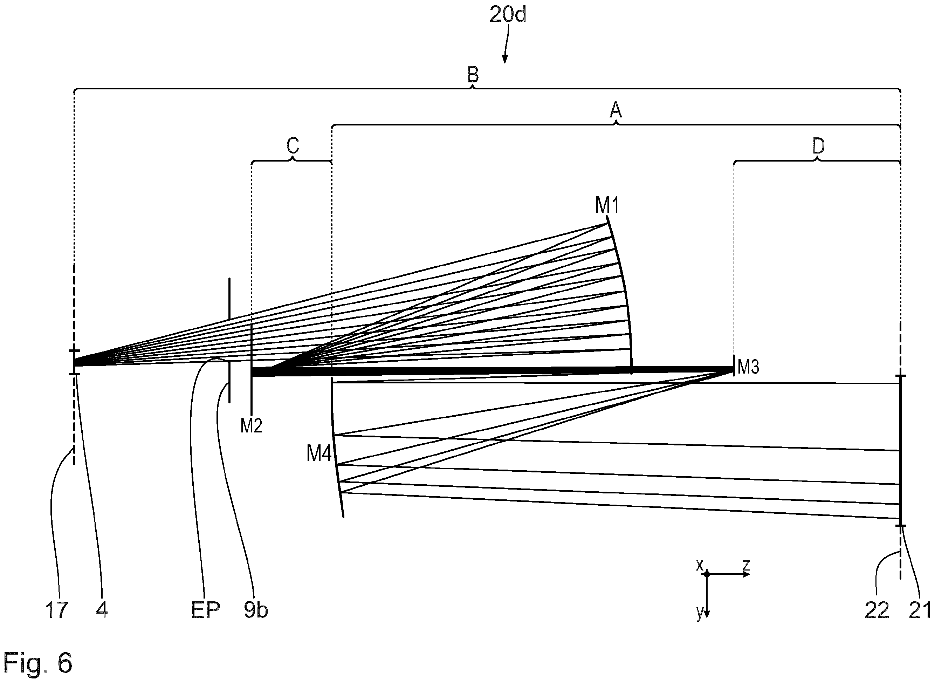

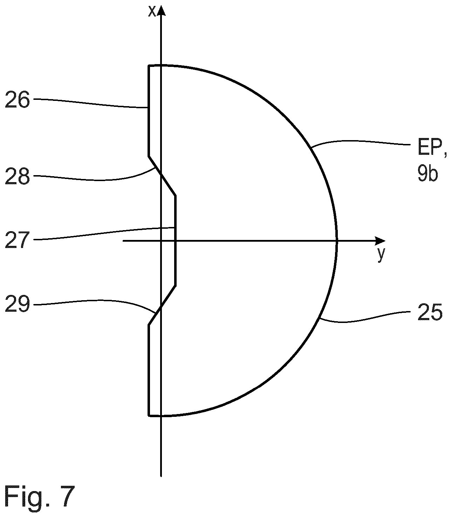

Anhand der Fig. 6 und 7 wird nachfolgend eine weitere Ausführung einer Projektionsoptik 20d erläutert, die anstelle der vorstehend beschriebenen Projektionsoptiken beim Maskeninspektionssystem 2a zum Einsatz kommen kann. Komponenten und Funktionen, die denjenigen entsprechen, die vorstehend unter Bezugnahme auf die Fig. 1 bis 5 bereits beschrieben wurden, tragen insbesondere die gleichen Bezugsziffern und werden nicht nochmals im Einzelnen diskutiert.

Die objektfeldseitige numerische Apertur NAx beträgt bei der Projektionsoptik 20d 0,25. Die objektfeldseitige numerische Apertur NAy beträgt 0,125. Die objektseitige Feldgröße beträgt 0.56mm x 0.36mm mit einem Offset des Feldes von 0.06mm in y.

Auch die Projektionsoptik 20d hat vier Spiegel M1 bis M4. Ein Strahlengang ist bei der Projektionsoptik 20d um die xz-Ebene gespiegelt im Vergleich zum Strahlengang der Projektionsoptik 20c dargestellt. Ansonsten entspricht der Strahlengang innerhalb der Projektionsoptik 20d grundsätzlich demjenigen innerhalb der Projektionsoptik 20c.

Für das Abstandsverhältnis A zu B gilt bei der Projektionsoptik 20d:

$$A/B \simeq 69\%$$

Die weiteren Abstandsverhältnisse sind:

$$C/B \simeq 10\%$$

$$D/B \simeq 20\%$$

Fig. 7 zeigt eine Randkontur der Eintrittspupille EP, die gleichzeitig einer inneren Berandungskontur der Aperturblende 9b entspricht. Die Eintrittspupille EP der Projektionsoptik 20d hat eine Berandungsform, die einen halbkreisförmigen Berandungsabschnitt 25 und einen Durchmesser-Berandungsabschnitt 26 aufweist. Längs des Durchmesser-Berandungsabschnitts 26, der zusammen mit dem halbkreisförmigen Berandungsabschnitt 25 eine gesamte Berandung der Eintrittspupille EP ergibt, liegt ein Aussparungsabschnitt 27 in der Berandung der Eintrittspupille EP vor. Eine zentrale Aussparung dieses Aussparungsabschnitts 27 verläuft parallel zum Durchmesser-Berandungsabschnitt 26 in positiver y-Richtung zu diesem versetzt. Diese zentrale Aussparung des Aussparungsabschnitts 27 geht über zwei schräge Berandungsabschnitte 28, 29 in den Durchmesser-Berandungsabschnitt 26 über.

Ein y-Abstand des zentralen Aussparungsabschnitts 27 zum Durchmesser-Berandungsabschnitt 26 ist kleiner als 15% einer y-Erstreckung der gesamten Eintrittspupille EP. Die gesamte Aussparung im Durchmesser-Berandungsabschnitt hat also im Vergleich zur halbkreisförmigen Einhüllenden um die Eintrittspupille EP und auch im Vergleich zur Fläche der Eintrittspupille EP selbst eine vernachlässigbare Fläche.

Der Aussparungsabschnitt 27 ist bedingt durch eine Obskuration der Eintrittspupille EP, die vom Spiegel M2 der Projektionsoptik 20d hervorgerufen wird.

Ein Vergrößerungsverhältnis ist bei der Projektionsoptik 20d 435.

Ein Wellenfrontfehler RMS über das Bildfeld 21 beträgt bei der Projektionsoptik 20d 15 mλ.

Ein bildfeldseitiger Petzvalradius ist bei der Projektionsoptik 20d im Bereich von 20.000 mm.

Nachfolgend sind optische Designdaten zur Projektionsoptik 20d wiederum in zwei Tabellen zusammengefasst, die hinsichtlich ihres Aufbaus den Tabellen zu den Fig. 4 und 5, also zur Projektionsoptik 20c entsprechen.

Tabelle 1a/b zu Fig. 6/7

| Optische Fläche | Radius [mm] | Radius bestangepasste Sphäre [mm] | Dicke[mm] | Wirkung |
|---|---|---|---|---|
| Objektfeld | Unendlich | | 0.000 | |
| 1: | Unendlich | | 196.000 | |
| Aperturblende | Unendlich | | 0.000 | |
| 3: | Unendlich | | 479.56 | |
| M1 | 527.767 | 528.588 | -459.1 | reflektierend |
| M2 | 50.000 | 50.095 | 584.25 | reflektierend |
| M3 | 44.030 | 44.03 | -489.63 | reflektierend |
| M4 | 1263.26 | 1264.587 | 688.9 | reflektierend |
| Bildfeld | Unendlich | | 0.000000 | |

Tabelle 1b zu Fig. 6/7

| Optische Fläche | Max. Einfallshöhe [mm] | Max. Abweichung Asphäre von Sphäre [mm] |
|---|---|---|
| Objektfeld | | |
| 1: | | |
| Aperturblende | | |
| 3: | | |
| M1 | 170 | 0.012 |
| M2 | 10.5 | 0.0006 |
| M3 | 7.6 | 0 |
| M4 | 180 | 0.004 |
| Bildfeld | | |

Tabelle 2 zu Fig. 6/7

| Spiegel | K | $C_1$ | $C_2$ | $C_3$ | $C_4$ |
|---|---|---|---|---|---|
| M1 | -0.0584 | 0.000E+00 | 0.17E-17 | 0.666E-23 | 0 |
| M2 | -0.161 | 0.000E+00 | 0.438E-10 | 0.5450E-14 | 0.642E-17 |

(fortgesetzt)

| Spiegel | K | $C_1$ | $C_2$ | $C_3$ | $C_4$ |
|---|---|---|---|---|---|
| M4 | -0.205 | 0.000E+00 | -3.1 E-18 | 0.5 E-22 | -1E-28 |

Die asphärischen Spiegel der Projektionsoptik 20a und auch die asphärischen Spiegel M1, M2 und M4 der Projektionsoptiken 20c und 20d haben Reflexionsflächen, die von einer sphärischen Form von höchstens 25 $\mu$m abweichen. Die hinsichtlich der Ausdehnung der Reflexionsflächen kleinen Spiegel M2 und M3, die auch als Kleinflächen-Spiegel mit einem Reflexionsflächenmesser kleiner als 50 mm bezeichnet werden, weichen von einer sphärischen Form um höchstens 5 $\mu$m ab. Bei den Projektionsoptiken 20c und 20d weicht der jeweils sphärische Spiegel M3 überhaupt nicht von einer sphärischen Form ab.

Ein Beleuchtungslicht-Strahlengang des Beleuchtungslichts 3 zur Beleuchtung des Retikels 18 und ein Abbildungslicht-Strahlengang der Projektionsoptik 20a zur Abbildung des Objektfeldes 4 in das Bildfeld 21 kreuzen sich in einem Kreuzungsbereich. Dieser Kreuzungsbereich kann im Bereich der Eintrittspupillen-Ebene EP der Projektionsoptik 20a liegen. Der Abbildungslicht-Strahlengang kreuzt sich hier mit dem Beleuchtungslicht-Strahlengang zwischen der Austrittsöffnung 14 und dem Spiegel IL2 der Beleuchtungsoptik 1 sowie zwischen den Spiegeln IL2 und IL3 der Beleuchtungsoptik 1.

Das Bildfeld 21 wird von einer Detektionseinrichtung 23, z. B. von einer CCD-Kamera oder mehreren CCD-Kameras, erfasst. Für Details der Abbildung in das Bildfeld wird auf die US 10,042,248 B2 sowie die in der US 10,042,248 B2 angegebenen Referenzen verwiesen. Die Detektionseinrichtung 23 kann auch als TDI (time delay integration, Integration mit zeitlicher Verzögerung)-Detektionseinrichtung mit einer Mehrzahl von TDI-Detektoren ausgeführt sein.

Die Detektionseinrichtung 23 ist ortsauflösend ausgeführt. Die Detektionseinrichtung 23 kann Sensorpixel mit einer typischen Pixelgröße von höchstens 20 $\mu$m x 20 $\mu$m aufweisen. Diese Pixelgröße kann kleiner sein und kann beispielsweise 15 $\mu$m x 15 $\mu$m oder auch 10 $\mu$m x 10 $\mu$m betragen. Eine Pixeldimension längs einer Bildfeldkoordinate x und/oder y kann im Bereich zwischen 1 $\mu$m und 20 $\mu$m liegen.

Mit dem Maskeninspektionssystem 2a ist eine Inspektion beispielsweise einer Struktur auf dem Retikel 18 möglich.

**Patentansprüche**

1. Vergrößernde abbildende Optik (20a; 20b; 20c; 20d) für ein Metrologiesystem (2a) zur Untersuchung von Objekten (18),

   - mit höchstens 4 Spiegeln (M1, M2; M3; M1, M2, M3, M4), die ein Objektfeld (4) in einer Objektebene (17) in ein Bildfeld (21) in einer Bildebene (22) längs eines Abbildungsstrahlengangs abbilden,
   - mit einer Eintrittspupille (EP) mit einer von einer Ellipse abweichenden Berandungsform, deren Aspektverhältnis ungleich 1 ist.

2. Vergrößernde abbildende Optik nach Anspruch 1, **dadurch gekennzeichnet, dass** die Eintrittspupille (EP) eine Berandungsform aufweist, die einen halbkreisförmigen Berandungsabschnitt (25) aufweist.

3. Vergrößernde abbildende Optik nach Anspruch 2, **dadurch gekennzeichnet, dass** längs eines Durchmesser-Berandungsabschnitts (26), der zusammen mit dem halbkreisförmigen Berandungsabschnitt (25) eine gesamte Berandung der Eintrittspupille (EP) ergibt, ein Aussparungsabschnitt (27) in der Berandung vorliegt.

4. Vergrößernde abbildende Optik nach einem der Ansprüche 1 bis 3, **gekennzeichnet durch** mindestens einen Spiegel (M1; M1, M2) mit einer Berandung an der Reflexionsfläche, die zur Führung von Abbildungslicht (3) längs des Abbildungsstrahlengangs genutzt wird, die der Berandung der Eintrittspupille (EP) entspricht.

5. Vergrößernde abbildende Optik (20a; 20b; 20c; 20d) nach einem der Anpsrüche 1 bis 4, wobei mindestens einer der Spiegel ein Kleinflächen-Spiegel (M2, M3) ist mit einem Durchmesser der Reflexionsfläche, der kleiner ist als 50mm,

   - wobei die Reflexionsfläche des Kleinflächen-Spiegels (M2, M3) von einer sphärischen Form um höchstens 10 $\mu$m abweicht.

6.  Vergrößernde abbildende Optik nach Anspruch 5, **gekennzeichnet dadurch, dass** die Reflexionsflächen aller Spiegel von einer sphärischen Form um höchstens 25 µm abweichen.

7.  Vergrößernde abbildende Optik nach einem der Ansprüche 1 bis 6, wobei ein im Abbildungsstrahlengang letzter Spiegel (M3; M4) einen Abstand zur Bildebene (22) aufweist, der größer ist als 60 % eines Abstandes zwischen der Objektebene (17) und der Bildebene (22).

8.  Vergrößernde abbildende Optik nach einem der Ansprüche 1 bis 7, **gekennzeichnet durch** ein Vergrößerungsverhältnis im Bereich zwischen 250 und 500.

9.  Vergrößernde abbildende Optik nach einem der Ansprüche 1 bis 8,
    **dadurch gekennzeichnet, dass** kein Einzelstrahl innerhalb des Abbildungsstrahlengangs einen Einfallswinkel auf einem der Spiegel (M1, M2; M1 bis M4) hat, der größer ist als 14°.

10. Vergrößernde abbildende Optik nach einem der Ansprüche 1 bis 9,
    **dadurch gekennzeichnet, dass** der Abbildungsstrahlengang derart ausgeführt ist, dass das Abbildungslicht (3) auf das Bildfeld (21) mit einem Einfallswinkel auftrifft, der kleiner ist als 5°.

11. Vergrößernde abbildende Optik nach einem der Ansprüche 1 bis 10,
    **gekennzeichnet durch** einen maximalen RMS-Wellenfrontfehler von 50 m$\lambda$.

12. Vergrößernde abbildende Optik nach einem der Ansprüche 1 bis 11,
    **dadurch gekennzeichnet, dass** die Reflexionsfläche mindestens eines der Spiegel von einer sphärischen Form um mindestens das Doppelte einer Nutzwellenlänge abweicht.

13. Beleuchtungsoptik (1) für ein Metrologiesystem (2a) zur Untersuchung von Objekten (18),

    - mit einer Beleuchtungspupille, die angepasst ist an eine Eintrittspupille (EP) einer abbildenden Optik nach einem der Ansprüche 1 bis 12,
    - wobei die Beleuchtungspupille eine von einer Ellipse abweichende Berandungsform aufweist, deren Aspektverhältnis ungleich 1 ist.

14. Optisches System (2) mit einer abbildenden Optik (20a; 20b; 20c; 20d) nach einem der Ansprüche 1 bis 12 und mit einer Beleuchtungsoptik (1) zur Beleuchtung des Objektfeldes (4) mit Beleuchtungslicht (3).

15. Optisches System (13) mit einer Beleuchtungsoptik nach Anspruch 13.

16. Metrologiesystem (2a)

    - mit einem optischen System nach Anspruch 14 oder 15,
    - mit einer Lichtquelle (5),
    - mit einer das Bildfeld (21) erfassenden, ortsauflösenden Detektionseinrichtung (22).

2a

10,
IL1

1  VK  9  2  22

M3

M1

3

12

13

8

IL3

21
23

M2

3

20a

9a

IL2

4

17

18

11

6

5  15  14  16  20  19

z

y  x

Fig. 1

Fig. 2

Fig. 3

Fig. 4

EP 4 575 605 A1

Fig. 5

Fig. 6

EP 4 575 605 A1

Fig. 7

Europäisches Patentamt
European Patent Office
Office européen des brevets

# EUROPÄISCHER RECHERCHENBERICHT

Nummer der Anmeldung

EP 24 21 2390

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2017 215664 A1 (ZEISS CARL SMT GMBH [DE]) 7. März 2019 (2019-03-07) | 13 | INV. G02B17/06 |
| Y | * Absätze [0043] - [0066]; Ansprüche; Abbildungen * | 1,4-12, 14-16 | |
| A | | 2,3 | |
| | - - - - - | | |
| Y | US 10 690 544 B1 (MITCHELL THOMAS A [US]) 23. Juni 2020 (2020-06-23) * Spalte 2, Zeile 10 - Spalte 5, Zeile 50; Abbildungen * | 4 | |
| | - - - - - | | |
| Y | US 7 619 735 B2 (APPLIED MATERIALS ISRAEL LTD [IL]) 17. November 2009 (2009-11-17) | 1,4-12, 14-16 | |
| A | * Spalte 6, Zeile 6 - Spalte 13, Zeile 12; Abbildungen * | 2,3 | |
| | - - - - - | | |
| Y | US 5 724 121 A (MCKINLEY WILLIAM G [US] ET AL) 3. März 1998 (1998-03-03) | 5,6 | |
| A | * Spalte 2, Zeile 46 - Spalte 20, Zeile 47; Abbildungen * | 1,13 | |
| | - - - - - | | |

RECHERCHIERTE SACHGEBIETE (IPC)

G02B

Der vorliegende Recherchenbericht wurde für alle Patentansprüche erstellt

| Recherchenort | Abschlußdatum der Recherche | Prüfer |
|---|---|---|
| München | 30. April 2025 | Politsch, Erich |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 21 2390

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-04-2025

| Im Recherchenbericht angeführtes Patentdokument | Datum der Veröffentlichung | Mitglied(er) der Patentfamilie | Datum der Veröffentlichung |
|---|---|---|---|
| DE 102017215664 A1 | 07-03-2019 | DE 102017215664 A1 | 07-03-2019 |
|  |  | WO 2019048200 A1 | 14-03-2019 |
| US 10690544 B1 | 23-06-2020 | KEINE |  |
| US 7619735 B2 | 17-11-2009 | KEINE |  |
| US 5724121 A | 03-03-1998 | KEINE |  |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102023213267
- US 8842284 B
- US 20130250428 A1
- WO 2016012426 A1
- US 10042248 B2
- DE 10220815 A1
- WO 2012101269 A1
- DE 102010029050 A1
- DE 102011084255 A1
- DE 102010029049 A1
- WO 2009024164 A1

**In der Beschreibung aufgeführte Nicht-Patentliteratur**

- **J. D. MANGUS** ; **J. H. UNDERWOOD**. Optical Design of a Glancing Incidence X-ray Telescope. *Applied Optics*, 1969, vol. 8, 95